# EUROPEAN PATENT APPLICATION

(11) **EP 4 067 916 A1**
(43) Date of publication of application: **05.10.2022**
(21) Application number: 21305395.2
(22) Date of filing: 29.03.2021
(51) Int. Cl.: G01R 31/28, G01R 31/52, G01R 31/08, H01B 9/02, H02G 15/105, G01R 19/25

(54) **SHEATH VOLTAGE LIMITER (SVL) INTEGRITY MONITORING**

(71) Applicant: Nexans, 92400 Courbevoie (FR)
(72) Inventor: GASPARI, Roberto, 1182 Oslo (NO)
(74) Representative: Ipsilon

(57) **Abstract**

The present invention relates to a monitoring system (100) for monitoring the state of an electric cable system (1), wherein the electric cable system (1). The monitoring system (100) comprises a current sensor (112, 113, 114) for measuring a signal representative of the current through the sheath voltage limiter element (32, 33, 34) and a signal processing unit (115) connected to the current sensor (112, 113, 114). The signal processing unit (115) is configured to determining a parameter representative of the state of the sheath voltage limiter element (32, 33, 34) of the electric cable system (1) based on the signal from the current sensor (112, 113, 114). The present invention also relates to a method for monitoring the state of the sheath voltage limiter element (32, 33, 34) and a computer program product performing the steps of the method.

## Description

### FIELD OF THE INVENTION

The present invention relates to a monitoring system for monitoring the state of an electric cable system. The present invention also relates to a method for monitoring the state of a sheath voltage limiter element of an electric cable system. The present invention also relates to a computer program product.

### BACKGROUND OF THE INVENTION

Electric high voltage cables are typically provided with an integral metallic sheath. The metallic sheath serves two purposes:
First, with the outer metallic sheath of the cable grounded, the electric stress distribution within the insulation attains radial symmetry and is confined to the insulation. This is an important safety consideration.
Second, the sheath is often used as the essential ground return path to carry the fault current in the event of a line-to-ground fault on the system. Thus, it must be able to carry this current for the time required to operate the overcurrent protective device without overheating and damaging the cable.

To prevent corrosion of the metallic sheaths and armors, the latter must be shielded from the environment by nonmetallic coverings.

In the high voltage cables, the metallic sheath is invariably protected by an extruded layer of PVC or polyethylene (PE) or other materials. This protective covering or jacket is required for a number of reasons. In order to provide some degree of mechanical protection to the underlying shield or sheath, the jacket must be tough and resistant to deformation both during and after installation of the cable.

A damage of the outer sheath of HVAC cables will lead to a deterioration of the cable performances and to an early failure of the energy link. The presence of a damage will create an additional earthing point leading to additional losses and at moisture access point into the cable with localized corrosion aided by the circulating currents through the earthing.

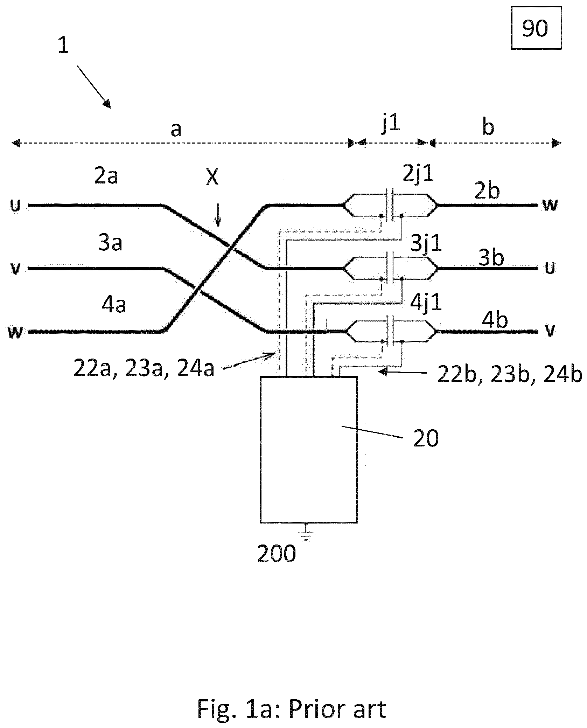

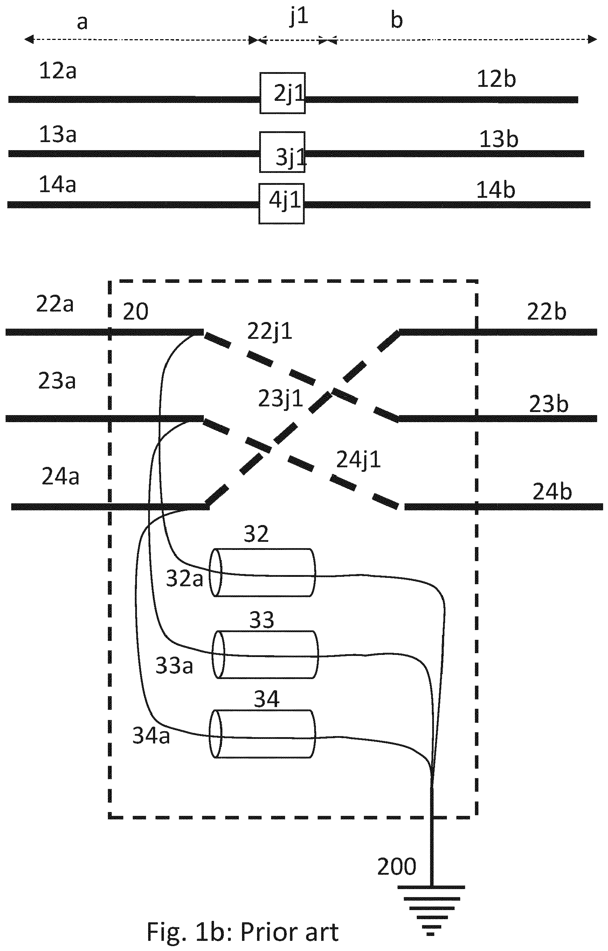

In fig. 1 a cable system 1 is shown to comprise two lengths a and b of a three phase cable, one for each phase U, V and W. The length a comprises a first cable section 2a, 3a, 4a and the length b comprises a second cable section 2b, 3b, 4b, the cable sections being joined by means of joints 2j 1, 3j 1, 4j 1. At the joints 2j 1, 3j 1, 4j 1, the conductors of the cable sections are connected to each other, while the sheaths of the respective cable sections are brought to a cross-bonding box 20.

Due to operational requirements, i.e. minimization of losses, the phases U, W, W, the cables and the metallic sheaths are transposed at intervals, as indicated with the letter X in fig. 1a.

In fig. 1b, the cross-bonding box 20 is shown in detail. Here, the sheets 22a, 23a, 24a of the first cable sections 2a, 3a, 4a are connected to sheets 22b, 23b, 24b of the second cable sections 2b, 3b, 4b via cross-bonding connectors 22j1, 23j1, 24j1. Above the cross-bonding box 20, it is also shown that the conductors 12a, 13a, 14a of the first cable section 2a, 3a, 4a are connected to the conductors 12b, 13b, 14b of the second cable section 2b, 3b, 4b by means of the joints 2j1, 3j1, 4j1.

The cross-bonding box 20 further comprises sheath voltage limiter elements 32, 33, 34 (hereinafter referred to as SVL elements) and earthing conductors 32a, 33a, 34a for connecting respective sheets 22a, 23a, 24a to ground 200 via the respective SVL elements 32, 33, 34. During normal operation, the current through the SVL elements are zero. However, current will go through the SVL elements in cases of overvoltage or lightning etc.

Over time, the integrity of the SVL elements will be reduced. i.e. their ability to route surges to ground and/or their ability to block current during normal operation, will be reduced.

One object of the present invention is to provide a monitoring system for monitoring of a cable system where the integrity of the SVL elements can be verified with the cable system in normal operation.

One object of the present invention is also to provide a method for monitoring of the cable system where the integrity of the SVL elements can be verified with the cable system in normal operation.

One object of the present invention is also to provide a computer program product for performing the above method.

### SUMMARY OF THE INVENTION

The present invention relates to a monitoring system for monitoring the state of an electric cable system, wherein the electric cable system comprises:
- a first cable section comprising a first conductor and a first sheath;
- a second cable section comprising a second conductor and a second sheath; wherein the first conductor is connected to the second conductor;
- a cross-bonding box, wherein the cross bonding box comprises:
- a conducting element for connecting the first sheath to the second sheath;
- a sheath voltage limiter element;
- an earthing conductor electrically connected between the first sheath and ground via the sheath voltage limiter element;
   characterized in that the monitoring system comprises:
- a current sensor for measuring a signal representative of the current through the sheath voltage limiter element;
- a signal processing unit connected to the current sensor;
   wherein the signal processing unit is configured to:
- determining a parameter representative of the state of the sheath voltage limiter element of the electric cable system based on the signal from the current sensor.

In one aspect, the current sensor comprises a Neel effect measuring coil.

In one aspect, the current sensor is located within the cross-bonding box.

In one aspect, the monitoring system comprises:
- a communication unit providing communication between the signal processing unit and a central control system;
wherein the parameter representative of the state of the sheath voltage limiter element is communicated from the processing unit to the central control system via the communication unit.

Alternatively, the signal processing unit is located distant from the sheath voltage limiter element, either as a part of the central control system or separate from the central control system. Here, the communication unit is providing communication between the sheath voltage limiter element and the signal processing unit, wherein the signal representative of the current through the sheath voltage limiter element is transferred by means of the communication unit from the sheath voltage limiter element and the signal processing unit.

In one aspect, the central control system is a control system of the electric cable system.

Typically, the central control system comprises a user interface for an operator of the electric cable system.

In one aspect, the parameter representative of the state of the sheath voltage limiter element of the electric cable system is a cumulated amount of electrical energy discharged across the sheath voltage limiter element over the period of time.

The cumulated amount of electrical energy discharged across the sheath voltage limiter element over the period of time may be indicative of an imminent error. If this cumulated amount of electrical energy discharged across the sheath voltage limiter element over the period of time is exceeding a threshold value, the risk of malfunction of the sheath voltage the sheath voltage limiter element is considered high, and the sheath voltage limiter element should be replaced. However, as long as this cumulated amount of electrical energy discharged across the sheath voltage limiter element over the period of time is not exceeding the threshold value, the risk of malfunction of the sheath voltage limiter element is considered low.

In one aspect, the cumulated amount of electrical energy is calculated by means of the current through the sheath voltage limiter element over a period of time and the nominal surge voltage of the sheath voltage limiter element.

In one aspect, the parameter representative of the state of the sheath voltage limiter element of the electric cable system is a number of discharges.

In one aspect, the parameter representative of the state of the sheath voltage limiter element of the electric cable system is a continuous current exceeding a predetermined threshold value flowing through the sheath voltage limiter element.

Under normal operation, the sheath voltage limiter element is typically not conducting any current. If surges occur, the surge current will be routed to ground via the sheath voltage limiter element. Hence, a continuous current flowing through the sheath voltage limiter element is indicative of an error or an imminent error.

The present invention also relates to a method for monitoring the state of a sheath voltage limiter element of an electric cable system, wherein the method comprises the steps of:
- measuring a signal representative of the current through the sheath voltage limiter element;
- determining a parameter representative of the state of the sheath voltage limiter element of the electric cable system based on the signal from the current sensor.

In one aspect, the method further comprising the step of:
- determining the parameter representative of the state of the sheath voltage limiter element of the electric cable system as a cumulated amount of electrical energy discharged across the sheath voltage limiter element over the period of time.

In one aspect, the method further comprises the step of:
- determining the parameter representative of the state of the sheath voltage limiter element of the electric cable system a number of discharges.

In one aspect, the method further comprises the step of:
- determining the parameter representative of the state of the sheath voltage limiter element of the electric cable system as a continuous current exceeding a predetermined threshold value flowing through the sheath voltage limiter element.

The present invention also relates to a computer program product, comprising a non-transitory computer readable storage medium comprising instructions that, when executed on a signal processing unit in a monitoring system, causes the signal processing unit to perform the steps of the above method.

According to the above, it is achieved a system and method which can be retrofitted to an existing cable system, as there is no need for a sensing element being embedded into the cable during production.

According to the above, it is achieved a system and method which can be used during normal operation of the cable. Hence, there is no need to take the cable out of operation to perform monitoring.

### DETAILED DESCRIPTION

Embodiments of the invention will now be described with reference to the enclosed drawings, wherein:
Fig. 1a illustrates a prior art three phase cable system;
Fig. 1b illustrates the prior art cross-bonding box of fig. 1a;
Fig. 2 illustrates a first embodiment of the monitoring system;
Fig. 3 illustrates a flow chart for a first embodiment of the method;
Fig. 4 illustrates an alternative embodiment of the monitoring system.

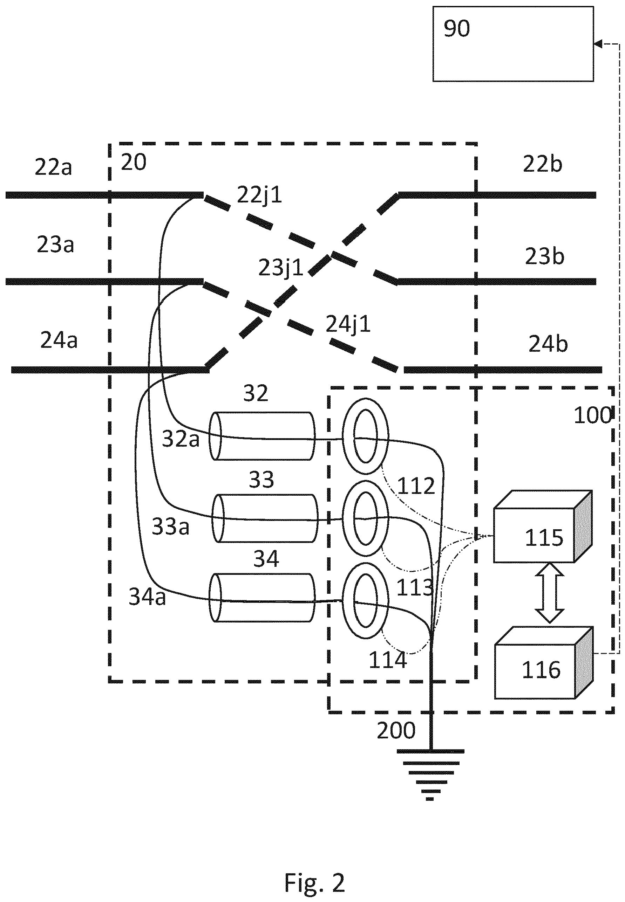

It is now referred to fig. 2, which corresponds to fig. 1b described in the introduction above. It should be noted that the conductors 12a, 13a, 14a of the first cable section 2a, 3a, 4a and the conductors 12b, 13b, 14b of the second cable section 2b, 3b, 4b have been removed in fig. 2.

As used herein, the term "cable section" refers to a length of cable of the cable system 1, as indicated by dashed arrows a, b in fig. 1. The cable section may comprise one conductor. The cable section may comprise three conductors, one for each phase. Each conductor has its own sheath, but each pair of conductor/sheath may be integrated in one cable or may be provided as three separate cables.

Initially, it should be noted that under normal operation, a sheath voltage limiter element (hereinafter referred to as a SVL element) is typically not conducting any current. If a surge occurs (typical surges are transients in the cable system), the surge current will be routed to ground via the SVL element. Hence, in many cases it may assumed that a surge is a short-lived occurrence, where the time between each surge is very long compared with the duration of the surge.

One of the technical characteristics of the SVL element is its nominal surge voltage rating. It should be noted that for a three phase system, a surge may be present in the sheath of one phase, or in several phases. The SVL elements are therefore operating independent of each other.

In addition, fig. 2 shows a monitoring system, generally indicated as a dashed box 100.

The monitoring system 100 comprises a first current sensor 112 for the first voltage limiter element 32, a second current sensor 113 for the second voltage limiter element 33 and a third current sensor 113 for the third voltage limiter element 34.

The current sensors 112, 113, 114 are Neel effect measuring coils. These Need effect measuring coils are relatively small in size, and can therefore be located within the cross-bonding box 20. Hence, this makes it easy to retrofit the monitoring system 100 to existing cable systems 1.

The current sensors 112, 113, 114 are connected to a signal processing unit 115, which is receiving a signal representative of the current through the respective SVL elements 32, 33, 34.

The monitoring system 100 further comprises a communication unit 116 providing communication between the signal processing unit 115 and a central control system 90. Preferably, the central control system 90 is a control system of the electric cable system 1. The central control system 90 preferably has a user interface to show the state of the SVL elements 32, 33, 34 and other states and/or parameters of the cable system 1.

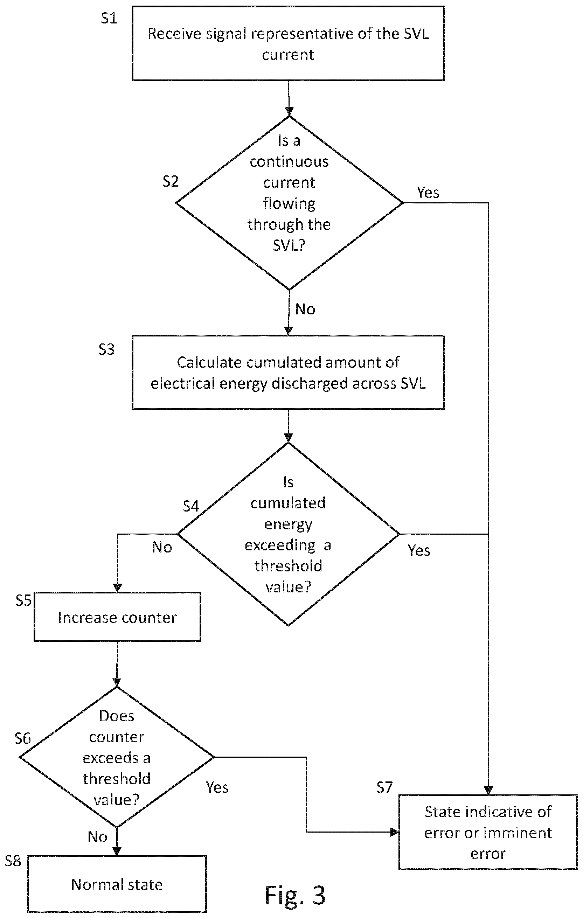

The method of monitoring the state of the of the SVL element will now be described with reference to fig. 3.

Initially, at step S1, the signal processing unit 115 is receiving the signal representative of the sheath voltage limiter as a continuous signal or as a discrete signal over a period of time. As described above, when the SVL element is working as normal and the cable system 1 is operating as normal (i.e. no surges are present), the current through the SVL element will be zero. This zero current is a parameter representative of a normal state for the SVL element (indicated as S8 in fig. 3).

At step S2, the signal processing unit 115 is determining if the current flowing through the SVL element is a continuous current exceeding a predetermined threshold value. This predetermined threshold value may be a low value, for example 0.1 A.

If it is determined that there is a continuous current flowing through the SVL element, this is indicative of an error or an imminent error (indicated at S7).

At step S3, the signal processing unit 115 is determining if a cumulated amount of electrical energy discharged across the SVL element over the period of time is exceeding a predetermined threshold value. The cumulated amount of electrical energy discharged across the SVL element over the period of time may be indicative of the wear and tear of the SVL element and may therefore be indicative of remaining operative time and/or the risk for malfunction of the SVL element. Hence, also the cumulated energy is indicative of an imminent error (indicated at S7). It is now recommended that the SVL element should be replaced.

The period of time may here be the total operation time for the SVL element, i.e. the time from the SVL element was installed. The predetermined threshold value for the cumulative amount of electrical energy will be set dependent on a number of factors, including the parameters of the cable system itself.

The cumulated amount energy may be calculated as the current through the SVL element multiplied with the nominal surge voltage rating of the SVL element over the period of time.

As long as this cumulated amount of electrical energy discharged across the SVL element 32, 33, 34 over the period of time is not exceeding the threshold value, the risk of malfunction of the SVL element 32, 33, 34 is considered low and normal operation is continued.

In step S5, the signal processing unit 115 is counting the number of discharges over the SVL element. As described above, it is possible to identify a surge as a short-lived current between longer periods in which no current is present.

In step S6, the signal processing unit 115 is determining if the counted number of discharges over the SVL element exceeds a predetermined threshold value. Similar to the cumulated amount of electrical energy discharged across the SVL element over the period of time, also the number of discharges over the SVL element may be indicative of the wear and tear of the SVL element. Hence, also the number of discharges is indicative of an imminent error (indicated at S7).

The above method will typically be performed by a computer program executed on the signal processing unit 115. It should be noted that the signal processing unit 115 itself does not need to determine if the SVL element should be replaced or when it should be replaced. This can be a manual operation, or an automatic operation, wherein additional factors than those mentioned above may be taken into consideration (for example economic factors and/or other technical factors).

### Alternative embodiments

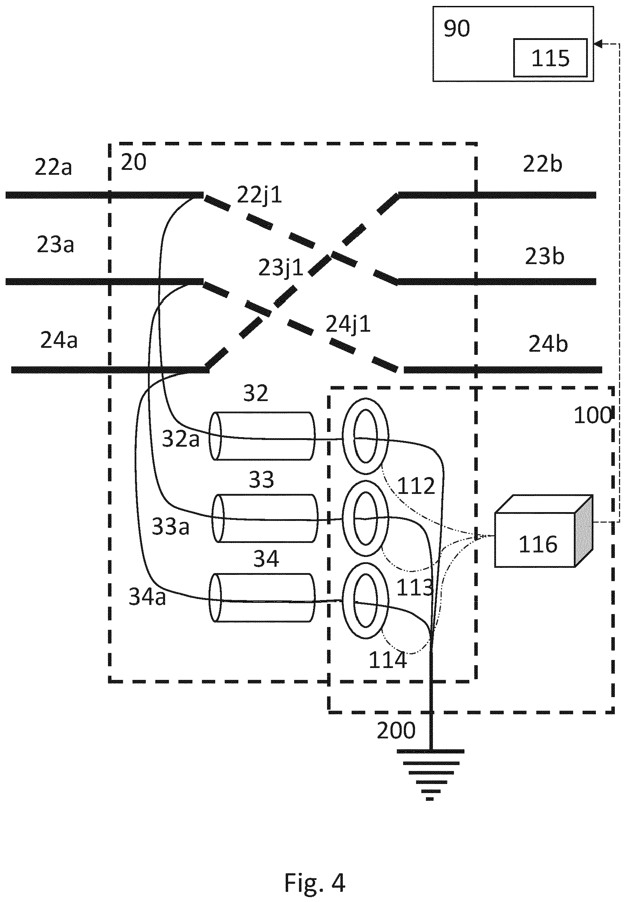

It is now referred to fig. 4. Here it is shown that the signal processing unit 115 is located distant from the sheath voltage limiter element and is implemented as part of the central control system 90. Here, the communication unit 116 is providing communication between the sheath voltage limiter element and the signal processing unit, wherein the signal representative of the current through the sheath voltage limiter element is transferred by means of the communication unit from the sheath voltage limiter element and the signal processing unit.

It should also be mentioned that the method described above may use only one or two of either the continuous current determination (step S2), the cumulated amount of electrical energy determination (steps S3 and S4) and/or the number of discharges determination (steps S5 and S6) as the parameter(s) representative of the state of the sheath voltage limiter element.

## Claims

1. Monitoring system (100) for monitoring the state of an electric cable system (1), wherein the electric cable system (1) comprises:
- a first cable section (2a, 3a, 4a) comprising a first conductor (12a, 13a, 14a) and a first sheath (22a, 23a, 24a);
- a second cable section (2b, 3b, 4b) comprising a second conductor (12b, 13b, 14b) and a second sheath (22b, 23b, 24b); wherein the first conductor (12a, 13a, 14a) is connected to the second conductor (12b, 13b, 14b);
- a cross-bonding box (20), wherein the cross bonding box (20) comprises:
- a conducting element (22j 1, 23j 1, 24j 1) for connecting the first sheath (22a, 23a, 24a) to the second sheath (22b, 23b, 24b);
- a sheath voltage limiter element (32, 33, 34);
- an earthing conductor (32a, 33a, 34a) electrically connected between the first sheath (22a, 23a, 24a) and ground (200) via the sheath voltage limiter element (32, 33, 34);
**characterized in that** the monitoring system (100) comprises:
- a current sensor (112, 113, 114) for measuring a signal representative of the current through the sheath voltage limiter element (32, 33, 34);
- a signal processing unit (115) connected to the current sensor (112, 113, 114); wherein the signal processing unit (115) is configured to:
- determining a parameter representative of the state of the sheath voltage limiter element (32, 33, 34) of the electric cable system (1) based on the signal from the current sensor (112, 113, 114).

2. Monitoring system (100) according to claim 1, wherein the current sensor (112, 113, 114) comprises a Neel effect measuring coil.

3. Monitoring system (100) according to claim 1 or 2, wherein the current sensor (112, 113, 114) is located within the cross-bonding box (20).

4. Monitoring system (100) according to any one of the above claims, wherein the monitoring system (100) comprises:
- a communication unit (116) providing communication between the signal processing unit (115) and a central control system (90);
wherein the parameter representative of the state of the sheath voltage limiter element (32, 33, 34) is communicated from the processing unit (115) to the central control system (90) via the communication unit (116).

5. Monitoring system (100) according to claim 4, wherein the central control system (90) is a control system of the electric cable system (1).

6. Monitoring system (100) according to any one of the above claims, wherein the parameter representative of the state of the sheath voltage limiter element (32, 33, 34) of the electric cable system (1) is a cumulated amount of electrical energy discharged across the sheath voltage limiter element (32, 33, 34) over the period of time.

7. Monitoring system (100) according to claim 6, wherein the cumulated amount of electrical energy is calculated by means of the current through the sheath voltage limiter element (32, 33, 34) over a period of time and the nominal surge voltage of the sheath voltage limiter element (32, 33, 34).

8. Monitoring system (100) according to claim 7, wherein the parameter representative of the state of the sheath voltage limiter element (32, 33, 34) of the electric cable system (1) is a number of discharges.

9. Monitoring system (100) according to any one of the above claims, wherein the parameter representative of the state of the sheath voltage limiter element (32, 33, 34) of the electric cable system (1) is a continuous current exceeding a predetermined threshold value flowing through the sheath voltage limiter element (32, 33, 34).

10. Method for monitoring the state of a sheath voltage limiter element (32, 33, 34) of an electric cable system (1), wherein the method comprises the steps of:
- measuring a signal representative of the current through the sheath voltage limiter element (32, 33, 34);
- determining a parameter representative of the state of the sheath voltage limiter element (32, 33, 34) of the electric cable system (1) based on the signal from the current sensor (112, 113, 114).

11. Method according to claim 10, wherein the method further comprising the step of:
- determining the parameter representative of the state of the sheath voltage limiter element (32, 33, 34) of the electric cable system (1) as a cumulated amount of electrical energy discharged across the sheath voltage limiter element (32, 33, 34) over the period of time.

12. Method according to claim 11, wherein the method further comprises the step of:
- determining the parameter representative of the state of the sheath voltage limiter element (32, 33, 34) of the electric cable system (1) as a number of discharges.

13. Method according to any one of claims 10 - 12, wherein the method further comprises the step of:
- determining the parameter representative of the state of the sheath voltage limiter element (32, 33, 34) of the electric cable system (1) as a continuous current exceeding a predetermined threshold value flowing through the sheath voltage limiter element (32, 33, 34).

14. A computer program product, comprising a non-transitory computer readable storage medium comprising instructions that, when executed on a signal processing unit (115) in a monitoring system (100), causes the signal processing unit (115) to perform the steps of the method according to claim 10 - 13.
